(19) Europäisches Patentamt
European Patent Office
Office européen des brevets

(11) EP 4 321 881 A1

(12) EUROPEAN PATENT APPLICATION
published in accordance with Art. 153(4) EPC

(43) Date of publication:
14.02.2024 Bulletin 2024/07

(51) International Patent Classification (IPC):
*G01R 31/12* (2020.01)    *G01R 31/14* (2006.01)

(21) Application number: 22784510.4

(22) Date of filing: 23.03.2022

(52) Cooperative Patent Classification (CPC):
G01R 31/12; G01R 31/14

(86) International application number:
PCT/JP2022/013505

(87) International publication number:
WO 2022/215525 (13.10.2022 Gazette 2022/41)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 09.04.2021 JP 2021066735

(71) Applicant: Hitachi, Ltd.
Tokyo 100-8280 (JP)

(72) Inventors:
• KYU, I
Tokyo 100-8280 (JP)
• KATAYAMA, Shigeki
Tokyo 100-8280 (JP)
• YAMADA, Hiromichi
Tokyo 100-8280 (JP)

(74) Representative: MERH-IP Matias Erny Reichl
Hoffmann
Patentanwälte PartG mbB
Paul-Heyse-Strasse 29
80336 München (DE)

(54) **INSULATION DEGRADATION DIAGNOSIS MODEL CREATION DEVICE, INSULATION DEGRADATION DIAGNOSIS DEVICE, AND INSULATION DEGRADATION DIAGNOSIS METHOD**

(57)    Provided is an insulation degradation diagnosis apparatus that performs an insulation degradation diagnosis based on a partial discharge signal of an insulator, the device including: a characteristic diagram creation unit configured to create a φ-q-n characteristic diagram of a partial discharge signal of an insulator to be determined; an image creation unit configured to create a φ-q-n image having each pixel value based on each numerical value of a φ-q-n characteristic diagram; and a diagnosis unit configured to make a diagnosis on a presence or occurrence state of partial discharge in the insulator to be determined, using an insulation degradation diagnosis model which is created by learning a φ-q-n image having each pixel value based on each numerical value of a φ-q-n characteristic diagram of a partial discharge signal of an insulator for learning as training data associated with a presence or occurrence state of partial discharge.

FIG. 6

EP 4 321 881 A1

**Description**

Technical Field

The present invention relates to an insulation degradation diagnosis model creation apparatus, an insulation degradation diagnosis apparatus, and an insulation degradation diagnosis method.

Background Art

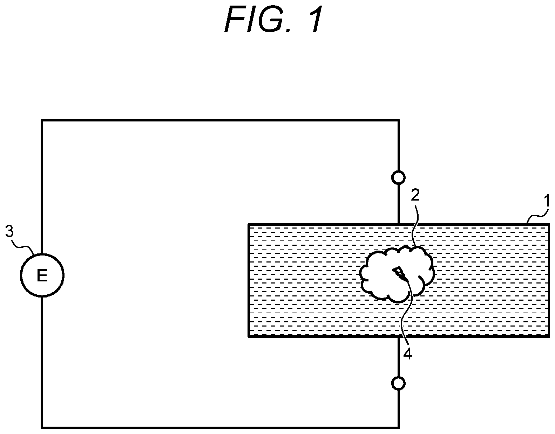

Insulation degradation of electrical devices will be described with reference to FIG. 1. FIG. 1 is a schematic diagram illustrating a mechanism of occurrence of partial discharge in an insulator 1. When the insulator 1 deteriorates due to, for example, aging, bubbles and impurities called voids 2 may be generated inside the insulator 1. When the voids 2 are generated, insulation performance of the insulator 1 deteriorates. Further, when the void 2 grows and the insulation performance of the insulator 1 falls below an applied voltage 3, dielectric breakdown occurs, and a large amount of damage occurs in the electrical device. Therefore, it is very important to identify a degradation state of the insulator 1 and to avoid dielectric breakdown in terms of the security of electrical devices.

Generally, since a dielectric constant of the void 2 is lower than that of a main body of the insulator 1, when the applied voltage 3 is applied to the insulator 1 before dielectric breakdown occurs, the voltage applied to the void 2 becomes higher than that of the surrounding insulator 1, and accordingly, the void 2 is short-circuited. When the void 2 is short-circuited, miniature charge transfer occurs, and local discharge also called partial discharge occurs.

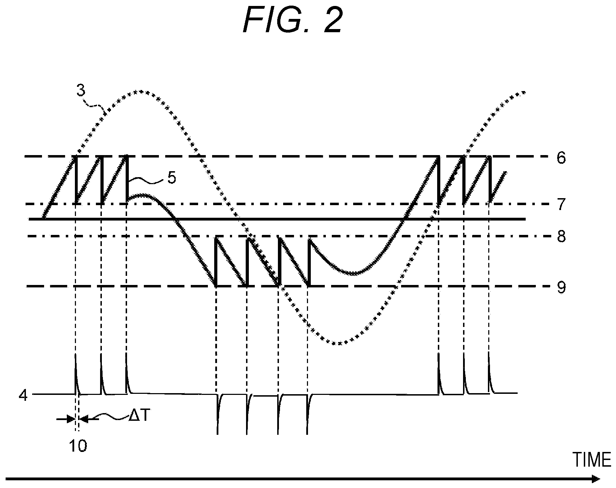

FIG. 2 is a time-series graph illustrating the mechanism of occurrence of partial discharge in the insulator 1. When the alternating-current applied voltage 3 is applied to the insulator 1, a voltage 5 is applied to the void 2, and charge is accumulated in the void 2.

(1) When the voltage 5 applied to the void 2 reaches a discharge start voltage (positive side) 6, the void 2 is short-circuited.

(2) When the void 2 is short-circuited, charges accumulated in the void 2 are discharged through a gap, and a pulsed discharge current 4 flows. The voltage 5 applied to the void 2 decreases to a voltage at which discharge stops (discharge extinction voltage (positive side) 7). Generally, a pulse time width $\Delta T$ of the discharge current is known to be a very short time of about 10 nsec.

(3) After the voltage 5 applied to the void 2 decreases to the discharge extinction voltage (positive side) 7, the gap due to the void 2 opens again and becomes non-conductive.

(4) When the applied voltage 3 increases, the void 2 is charged again by applying the voltage 5, and the process returns to (1) to repeat the operation.

If the sentences above are read with the discharge starting voltage (positive side) 6 replaced by a discharge starting voltage (negative side) 9 and the discharge extinction voltage (positive side) 7 replaced by a discharge extinction voltage (negative side) 8, the steps (1) to (4) would be the same when the applied voltage 3 is negative.

From the mechanism of occurrence of partial discharge shown in FIG. 2, it is considered that the partial discharge has the following three characteristics.

- The partial discharge occurs as a sign before dielectric breakdown occurs.
- There is a correlation between a phase of the partial discharge and a phase of the applied voltage.
- As the void 2 becomes larger, that is, as the insulation degradation progresses, the charge accumulated in the void 2 increases, and the partial discharge generated thereby also increases.

Accordingly, when an insulation degradation state is identified and estimated using a measured partial discharge signal, the insulation degradation state is generally analyzed using a $\varphi$-q characteristic diagram expressing a correlation between a charge amount of partial discharge generated during one cycle of a certain applied voltage and an applied voltage phase, and a $\varphi$-q-n characteristic diagram accumulating $\varphi$-q characteristics for a certain period of time and expressing a correlation between the charge amount of partial discharge, the number of occurrences thereof, and the applied voltage phase.

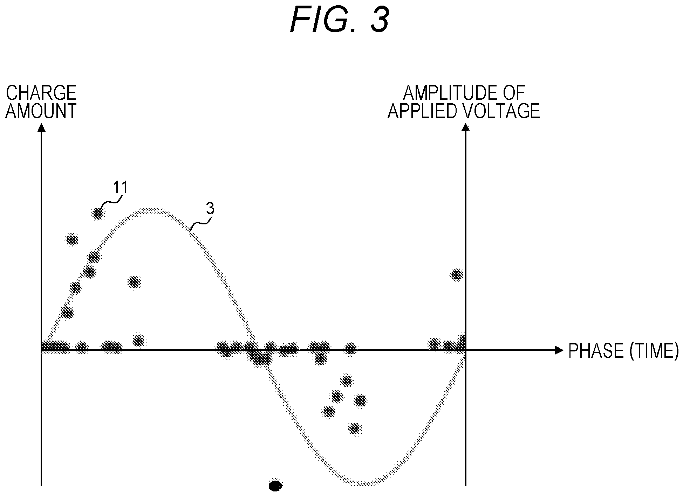

FIG. 3 is a diagram illustrating a method of creating a $\varphi$-q characteristic diagram. In FIG. 3, a vertical axis represents a charge amount, and a horizontal axis represents a time. One section of the time is a section from a phase of 0 degrees to 360 degrees per cycle with the applied voltage. As illustrated in FIG. 3, a $\varphi$-q characteristic diagram is obtained by plotting a measured charge amount 11 in accordance with a measuring time (phase).

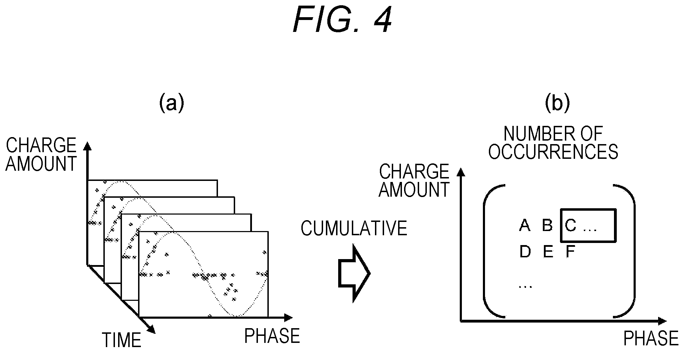

FIG. 4 is a diagram illustrating a method of creating a $\varphi$-q-n characteristic diagram. In FIG. 4, a vertical axis represents a charge amount, and a horizontal axis represents a phase. A value obtained by cumulatively adding the number of occurrences of charges generated in a certain phase from a plurality of φ-q characteristic diagrams created in a predetermined constant time as illustrated in FIG. 4(a) is expressed by a two-dimensional matrix as illustrated in FIG. 4(b), which is a φ-q-n characteristic diagram.

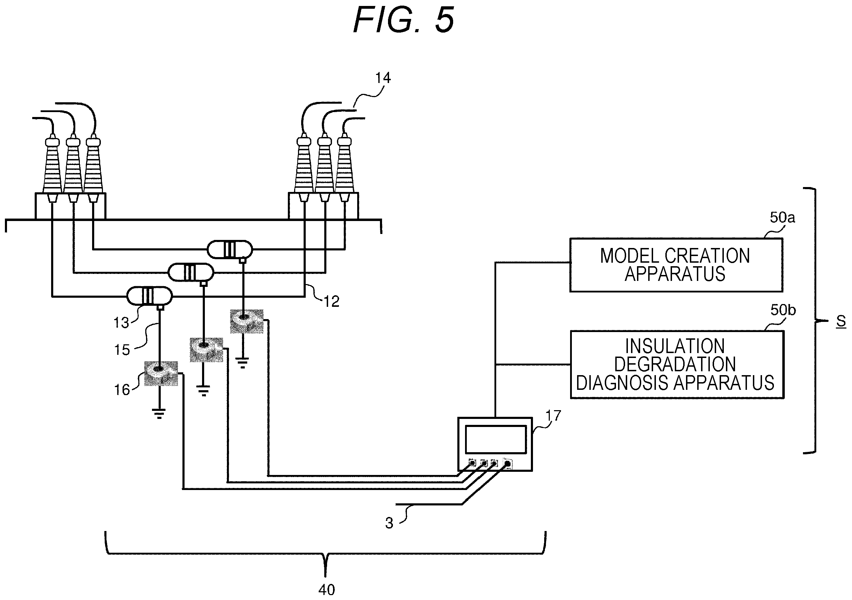

FIG. 5 is a diagram illustrating a configuration example of a partial discharge measurement system 40 in the underground power transmission grid. The partial discharge measurement system 40 includes a CT 16 and a measuring instrument 17. CT stands for a current transformer.

A three-phase underground cable 12 connects each of three-phase overhead cables 14 and may have a power cable connector 13 that is a cable joint in the middle of its path. It is assumed that the power cable connector 13 has a ground line 15. When partial discharge occurs in the underground cable 12 near the ground line 15, it is considered that the partial discharge current flows through the ground line 15.

Therefore, the phase of the partial discharge current flowing through the ground line 15 and the phase of the applied voltage 3 applied to the underground cable 12 are simultaneously measured by the measuring instrument 17, whereby a φ-q characteristic diagram and a φ-q-n characteristic diagram of the partial discharge can be created. The φ-q characteristic diagram and the φ-q-n characteristic diagram of the partial discharge are created by the measuring instrument 17 and the insulation degradation diagnosis apparatus 50b, respectively.

However, as described above, since a pulse width of the partial discharge is generally very short such as around 10 nsec, the CT 16 and the measuring instrument 17, each capable of measuring a MHz-class high frequency current, are required at the time of measurement. A charge amount q of the void 2 can be calculated by Equation (1) from the measured current value I(t) at a time t of the partial discharge.

$$q = \int I(t)\,dt \quad \ldots \quad (1)$$

For example, PTL 1 discloses a method for detecting anomalies by comparing a φ-q-n characteristic of a partial discharge signal with a φ-q-n characteristic of one cycle earlier as a method for diagnosing insulation degradation in electrical devices.

On the other hand, for example, PTL 2 discloses a method of estimating a state of an electrical device from an estimated amount of a size or shape of a gap formed in an insulating medium of the electrical device.

For example, PTL 3 discloses a method of performing machine learning on past signal data at a normal time and performing diagnosis by detecting a state different from a normal state. Further, for example, PTL 4 discloses a method of improving accuracy of mode determination for specifying a location where partial discharge has occurred by performing machine learning on a feature value obtained by singular value decomposition and Fourier transform on a signal.

Citation List

Patent Literatures

PTL 1: JP H05-80112 A
PTL 2: JP 2020-030125 A
PTL 3: JP 2020-046202 A
PTL 4: JP 2019-200068 A

Summary of Invention

Technical Problem

Conventionally, a feature value expressing a feature of partial discharge such as a statistic amount of a charge distribution in a specific phase region is examined from various viewpoints according to a target, and an insulation state of the target is evaluated based on the examined feature value of the partial discharge. The examination of the feature value of the partial discharge is based on the viewpoint of the expert who has a high level of knowledge about the target. However, when the target or situation changes, the feature of the partial discharge itself also changes, and thus, it is difficult to perform general-purpose evaluation.

In particular, the noise superimposed on the target's partial discharge signal in PTL 1 and the feature value of the gap formed in the target insulating medium in PTL 2 vary depending on, for example, the target device itself, the use method and the degradation state. The examination of the noise superimposed on the partial discharge signal and the feature value of the gap formed in the target insulating medium requires a high degree of knowledge about the target and data, and thus it is difficult to obtain a diagnosis logic that functions in a general-purpose manner.

PTL 3 does not describe a specific implementation method of machine learning, and has not been put into practical use due to diagnosis accuracy, difficult tuning, and difficult aspect determination. For PTL 4, it is considered that a large amount of data needs to be acquired to achieve practical use, which is unfeasible.

The expert can visually and qualitatively determine whether the insulation of any target is in a normal state or a deteriorated state based on the φ-q-n characteristic.

The present invention has been made considering such a problem, and an object of the present invention is to make visual determination on an insulation state of an electrical device based on a φ-q-n characteristic with reliability equivalent to that of experts.

Solution to Problem

For addressing the problem above, according to one aspect of the present invention, provided is an insulation degradation diagnosis model creation apparatus that creates an insulation degradation diagnosis model based on a partial discharge signal of an insulator, the device including: a characteristic diagram creation unit configured to create a φ-q-n characteristic diagram of a partial discharge signal of an insulator for learning; an image creation unit configured to create a φ-q-n image having each pixel value based on each numerical value of the φ-q-n characteristic diagram; and a model creation unit configured to create the insulation degradation diagnosis model by learning the φ-q-n image as training data associated with a presence or occurrence state of partial discharge.

Further, according to one aspect of the present invention, provided is an insulation degradation diagnosis apparatus that performs insulation degradation diagnosis based on a partial discharge signal of an insulator, the device including: a characteristic diagram creation unit configured to create a φ-q-n characteristic diagram of a partial discharge signal of an insulator to be determined; an image creation unit configured to create a φ-q-n image having each pixel value based on each numerical value of the φ-q-n characteristic diagram; and a diagnosis unit configured to make a diagnosis on a presence or occurrence state of partial discharge in the insulator to be determined from the φ-q-n image using an insulation degradation diagnosis model created by the insulation degradation diagnosis model creation apparatus.

Advantageous Effects of Invention

According to the present invention, it is possible to make visual determination on an insulation state of an electrical device based on a φ-q-n characteristic with reliability equivalent to that of experts.

Brief Description of Drawings

[FIG. 1] FIG. 1 is a schematic diagram illustrating a mechanism of occurrence of partial discharge in an insulator.
[FIG. 2] FIG. 2 is a time-series graph illustrating the mechanism of occurrence of partial discharge in the insulator.
[FIG. 3] FIG. 3 is a diagram illustrating a method of creating a φ-q characteristic diagram.
[FIG. 4] FIG. 4 is a diagram illustrating a method of creating a φ-q-n characteristic diagram.
[FIG. 5] FIG. 5 is a diagram illustrating a configuration example of a partial discharge measurement system in an underground power transmission grid.
[FIG. 6] FIG. 6 is a block diagram illustrating a configuration of a measuring instrument and a partial discharge determination system of Example 1.
[FIG. 7] FIG. 7 is a diagram illustrating one example of a method of calculating a generated charge amount at each time.
[FIG. 8] FIG. 8 is a diagram illustrating imaging of a φ-q-n characteristic diagram of Example 1 (and Example 2).
[FIG. 9] FIG. 9 is a flowchart illustrating model creation processing and diagnosis processing of the partial discharge determination system of Example 1.
[FIG. 10] FIG. 10 is a flowchart illustrating model creation processing and diagnosis processing of the partial discharge determination system of Example 2.
[FIG. 11] FIG. 11 is a diagram illustrating imaging of a φ-q-n characteristic diagram of Example 3.
[FIG. 12] FIG. 12 is a hardware diagram of a computer that implements a model creation apparatus and an insulation degradation diagnosis apparatus.

Description of Embodiments

Hereinafter, embodiments of the present invention will be described in detail with reference to the drawings. The following examples are not intended to limit the invention. Further, not all the elements and combinations thereof described in the following examples are essential to the solution of the present invention. Moreover, some or all of the examples and modifications can be combined within the scope of the technical idea of the present invention and to the extent consistent with each other.

In the following description, the same or similar functions or processes are denoted by the same reference numerals. Further, in the following description, descriptions of the configuration and processing described above will be omitted, or descriptions of the same configuration and processing as those of the examples described already will be omitted, while mainly focusing on differences therebetween.

Example 1

In the present example, anomaly determination is performed based on a correlation between a measured partial discharge signal and an applied voltage phase for insulation degradation of an electrical device. Specifically, the presence or level of occurrence of partial discharge is automatically determined from a $\varphi$-q-n characteristic diagram based on measurement data of a discharge current of an electrical device to be determined using a learning model obtained by machine learning of a $\varphi$-q-n image obtained by imaging the $\varphi$-q-n characteristic diagram based on the measurement data of the discharge current of the electrical device to be determined.

The $\varphi$-q-n characteristic varies depending on conditions such as physical parameters of the insulator, three phases, a cable type, and a use environment. It is assumed that a discriminant model is generated for each condition, and the partial discharge is determined using the discriminant model according to the condition.

(Configurations of Measuring Instrument 17, Model creation apparatus 50a, and Insulation degradation diagnosis apparatus 50b)

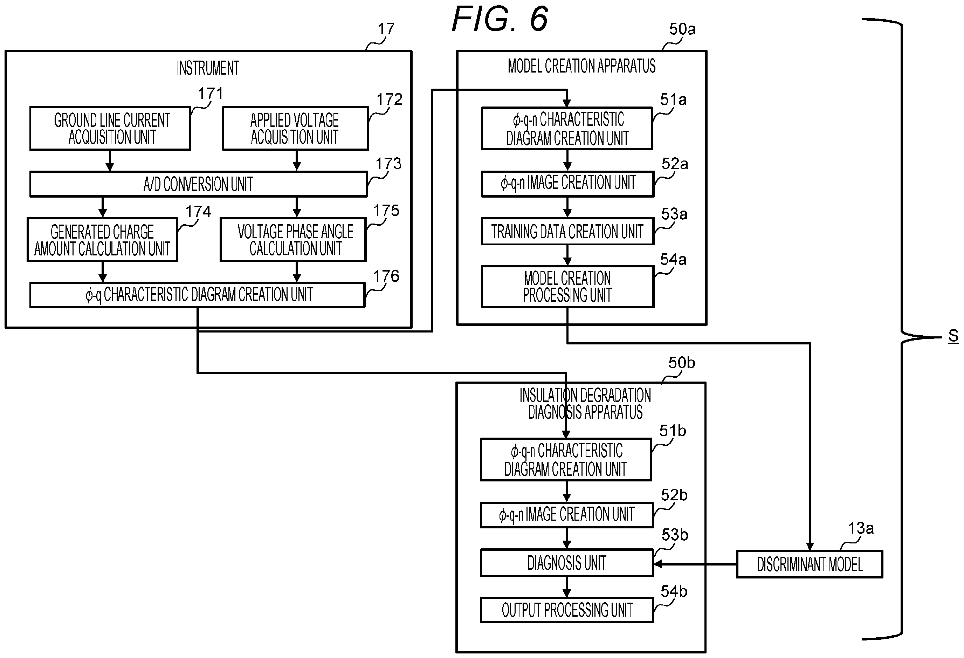

FIG. 6 is a block diagram illustrating a configuration of a measuring instrument 17 and a partial discharge determination system S of Example 1. The partial discharge determination system S includes a model creation apparatus 50a and an insulation degradation diagnosis apparatus 50b. The model creation apparatus 50a and the insulation degradation diagnosis apparatus 50b may be an integrated device or individual devices.

The measuring instrument 17 includes a ground line current acquisition unit 171, an applied voltage acquisition unit 172, an A/D converter 173, a generated charge amount calculation unit 174, a voltage phase angle calculation unit 175, and a $\varphi$-q characteristic diagram creation unit 176.

The ground line current acquisition unit 171 acquires a signal of the current (ground line current) of a ground line 15 of each phase measured by each CT 16 (FIG. 5). The applied voltage acquisition unit 172 acquires a signal of an applied voltage 3 (FIG. 5) to an insulator 1 of each phase. The A/D converter 173 performs analog-to-digital (A/D) conversion on the current acquired by the ground line current acquisition unit 171 and the voltage acquired by the applied voltage acquisition unit 172 at the same sampling timing. Since it is necessary to perform A/D conversion on the ground line current and the applied voltage 3 at the same sampling timing, it is a principle to perform measurement with the same measuring instrument 17.

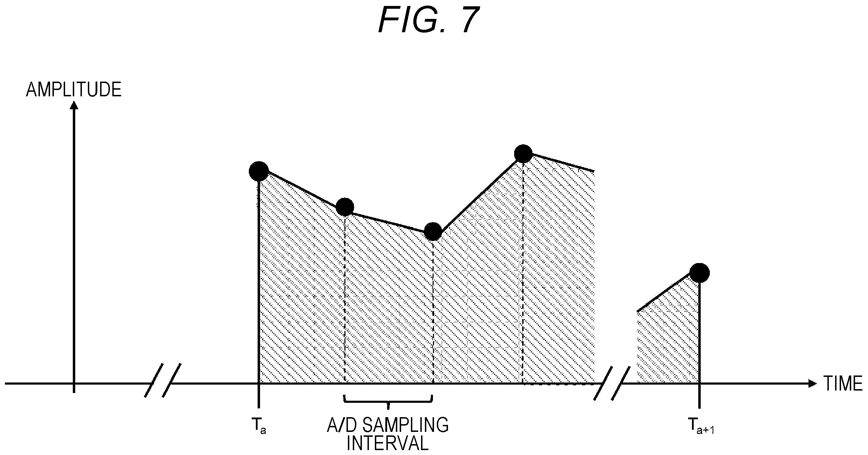

The generated charge amount calculation unit 174 calculates a generated charge amount at each time. FIG. 7 illustrates one example of a method of calculating a generated charge amount at each time. A sampling amount (amplitude) of the current is measured at each A/D sampling interval between the times $T_a$ to $T_{a+1}$ in FIG. 7. A value obtained by integrating the measured sampling amount between the times $T_a$ and $T_{a+1}$ as indicated by diagonal lines in FIG. 7 is defined as a charge amount generated within the times $T_a$ to $T_{a+1}$.

The voltage phase angle calculation unit 175 calculates a voltage phase angle at each time.

For the generated charge amount calculated by the generated charge amount calculation unit 174 and the voltage phase angle calculated by the voltage phase angle calculation unit 175, the $\varphi$-q characteristic diagram creation unit 176 creates a $\varphi$-q characteristic diagram by associating the generated charge amount and the voltage phase angle at the same time.

The model creation apparatus 50a will be described hereinbelow. The model creation apparatus 50a includes a $\varphi$-q-n characteristic diagram creation unit 51a, a $\varphi$-q-n image creation unit 52a, a training data creation unit 53a, and a model creation processing unit 54a.

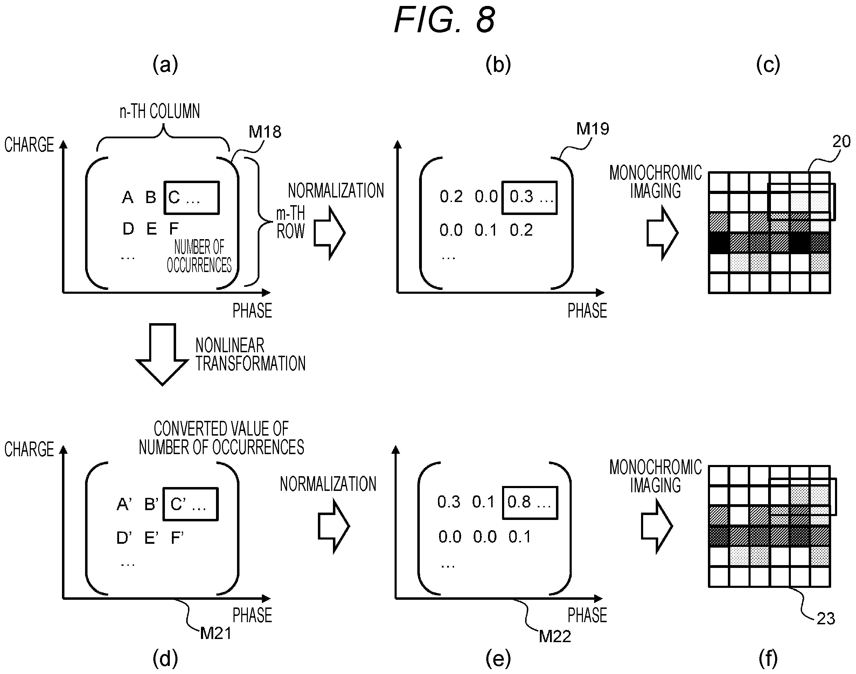

As will be described later with reference to FIG. 8, the $\varphi$-q-n characteristic diagram creation unit 51a creates a $\varphi$-q-n characteristic diagram (2D matrix M18 (FIG. 8(a)) from measurement data for learning ($\varphi$-q characteristic diagram). A 2D matrix M19 (FIG. 8(b)) is created in which each matrix component of the 2D matrix M18 is normalized. The $\varphi$-q-n image creation unit 52b creates a $\varphi$-q-n image by imaging the $\varphi$-q-n characteristic diagram (2D matrix M19).

The training data creation unit 53a executes data augmentation (for artificially increasing the size of training data) on the φ-q-n image created by the φ-q-n image creation unit 52b to create a large amount of training data group. The model creation processing unit 54a performs machine learning on the training data group created by the training data creation unit 53a to create a discriminant model 13a.

The insulation degradation diagnosis apparatus 50b will be described hereinbelow. The insulation degradation diagnosis apparatus 50b includes a φ-q-n characteristic diagram creation unit 51b, a φ-q-n image creation unit 52b, a diagnosis unit 53b, and an output processing unit 54b. The discriminant model 13a is stored in a storage area inside or outside the insulation degradation diagnosis apparatus 50b. As the discriminant model 13a, an appropriate model is selected according to factors, for example, a cable type (such as OF cables or OF cables) or a measurement environment.

Similarly to the φ-q-n characteristic diagram creation unit 51a of the model creation apparatus 50a, the φ-q-n characteristic diagram creation unit 51b creates a φ-q-n characteristic diagram (2D matrix M18 (FIG. 8(a)) from measurement data of the device to be determined (φ-q characteristic diagram). A 2D matrix M19 (FIG. 8(b)) is created in which each matrix component of the 2D matrix M18 is normalized. Similarly to the φ-q-n image creation unit 52a of the model creation apparatus 50a, the φ-q-n image creation unit 52b creates a φ-q-n image by imaging the φ-q-n characteristic diagram (2D matrix M19).

Imaging of the φ-q-n characteristic diagram will be described with reference to FIG. 8.

(Imaging of φ-q-n Characteristic Diagram of Example 1)

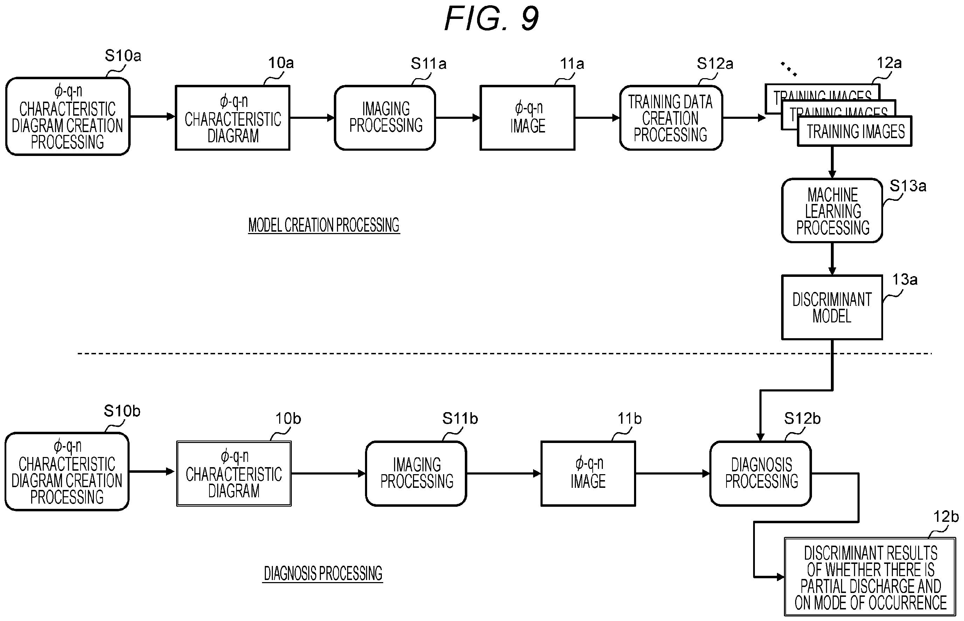

FIG. 8 is a diagram illustrating imaging of the φ-q-n characteristic diagram of Example 1. FIGS. 8(a), 8(b), and 8(c) illustrate imaging of the φ-q-n characteristic diagram of Example 1 executed in S11a and S11b (FIG. 9) described later. Example 1 illustrates an expression method in which the larger the number of occurrences of partial discharge is, the closer the color is to black, while the smaller the number of occurrences of partial discharge, the closer the color is to white by gray scale (black indicates a light intensity of 0%, and white indicates a light intensity of 100%). Hereinafter, the φ-q-n characteristic diagram is a 2D matrix M18 in which the number of occurrences is set as each matrix component as illustrated in FIG. 8(a). A size of the 2D matrix M 18 is m × n.

As illustrated in FIG. 8(b), a new m × n 2D matrix M19 having matrix components $c_{ij}'$ numerically transformed by Equation (2) for converting matrix components $c_{ij}$ of i-th row and j-th column of the 2D matrix M18 such that a matrix component $C_{max}$ corresponding to the maximum number of occurrences in data becomes 0 and the number of occurrences of 0 becomes 1 is generated.

$$c_{ij}' = f(c_{ij}) = (C_{max} - c_{ij})/C_{max} \cdots (2)$$

As illustrated in FIG. 8(c), a lattice image 20 is drawn as an image having a size m × n in which a lattice square of i-th row and j-th column corresponding to a matrix component $c_{ij}'$ is colored according to a luminance, regarding $c_{ij}'$ as the luminance of the grayscale of the light in a case where 0 is black (light intensity 0%) and 1 is white (light intensity 100%). In the lattice image 20 of FIG. 8(c), the larger the number of occurrences is, the closer the color is to black, and the smaller the number of occurrences is, the closer the color is to white. In the present example, the lattice images 20 are set as φ-q-n images 11a and 11b (FIG. 9) .

(Model Creation Processing and Diagnosis Processing of Partial Discharge Determination System S of Example 1)

FIG. 9 is a flowchart illustrating model creation processing and diagnosis processing of the partial discharge determination system S of Example 1. The model creation processing is executed by the model creation apparatus 50a (FIG. 6), and the diagnosis processing is executed by the insulation degradation diagnosis apparatus 50b (FIG. 6).

In the model creation processing of the partial discharge determination system S, the φ-q-n characteristic diagram creation unit 51a creates a φ-q-n characteristic diagram 10a with the φ-q characteristic diagram, which is measurement data for learning created by the φ-q characteristic diagram creation unit 176 of the measuring instrument 17, as an input, in S10a.

In S11a, the φ-q-n image creation unit 52a performs imaging processing on the φ-q-n characteristic diagram 10a to create a φ-q-n image 11a.

In S12a, the training data creation unit 53a performs data augmentation (for artificially increasing the size of training data) for superimposing a random noise on the φ-q-n image 11a by software, shifting a charge generation phase, or increasing or decreasing a charge amount. By the data augmentation, a training image group 12a is generated, which is a large amount of training data that the image for learning is associated with the presence and/or occurrence state of the partial discharge.

The superimposition of the random noise aims to improve noise tolerance of determination accuracy, and the data augmentation of the training data by phase shift aims to improve the determination accuracy in a case where a phase delay is included in the φ-q-n characteristic.

In S13a, the model creation processing unit 54a performs model creation processing on the training image group 12a, generates the discriminant model 13a, and stores the discriminant model 13a in a predetermined storage area.

On the other hand, in the diagnosis processing of the partial discharge determination system S, the φ-q-n characteristic diagram creation unit 51b creates a φ-q-n characteristic diagram 10b with the φ-q characteristic diagram, which is measurement data of the determination target created by the φ-q characteristic diagram creation unit 176 of the measuring instrument 17, as an input, in SIOb.

In S11b, the φ-q-n image creation unit 52b performs imaging processing on the φ-q-n characteristic diagram 10b to create a φ-q-n image 11b of the determination target.

In S12b, the diagnosis unit 53b uses the φ-q-n image 11b as an input of the discriminant model 13a, and obtains the determination result 12b indicating the presence and/or occurrence state of the partial discharge. The output processing unit 54b outputs the determination result 12b from the output device.

Example 2

In Example 1, the φ-q-n characteristic diagrams 10a and 10b are directly imaged. On the other hand, in Example 2, a discriminant model 13a1 is generated on the basis of a φ-q-n image 11a1 obtained by imaging a φ-q-n characteristic diagram 10a subject to nonlinear transformation performed on each matrix component of the φ-q-n characteristic diagram 10a. A φ-q-n image 11b1 obtained by imaging the φ-q-n characteristic diagram subject to nonlinear transformation performed on each matrix component of the φ-q-n characteristic diagram 10b of the determination target is used as an input of the discriminant model 13a1 to obtain the determination result 12b1 indicating the presence and/or occurrence state of the partial discharge.

In an initial stage when insulation degradation of the insulator starts, the generated charge amount of the partial discharge is very small, and image data obtained by imaging the φ-q-n characteristic as it is does not sufficiently express characteristics of the partial discharge. Accordingly it is considered that occurrence of partial discharge may be overlooked.

Therefore, in Example 2, as illustrated in FIGS. 8(a), 8(d), 8(e), and 8(f), a 2D matrix M21 obtained by performing nonlinear transformation on each matrix element of the 2D matrix M18 illustrated in Example 1 is generated, and a 2D matrix M22 obtained by normalizing each matrix element of the 2D matrix M 21 in the same manner as in Example 1 is imaged. Examples of the nonlinear transformation include Equations (3) to (5). In any case, a value of the matrix element before transformation is x, a value of the matrix element after transformation is g(x), and a denotes a transformation parameter.

Logarithmic transformation:

$$g(x) = \log_a(x) \quad \dots \quad (3)$$

Exponentiation transformation:

$$g(x) = x^a \quad \dots \quad (4)$$

$$\text{Sigmoid transformation: } g(x) = 1/(1+e^{-ax}) \quad (a > 0) \quad \dots \quad (5)$$

Each transformation of Equations (3) to (5) is processing of emphasizing a miniature charge amount. This can be expected to improve the determination accuracy of the presence or absence of the occurrence of the partial discharge. FIGS. 8(a), 8(d), 8(e), and 8(f) are diagrams each illustrating imaging processing involving nonlinear transformation.

As illustrated in FIG. 8(d), a new 2D matrix M21 is generated by numerically transforming each matrix component $c_{ij}$ (i-th row and j-th column) of the φ-q-n characteristic diagram before transformation (2D matrix M18) by any of the transformation expressed by Equations (3) to (5) described above.

As illustrated in FIG. 8(e), a new m × n 2D matrix M22 having matrix components $c_{ij}'''$ numerically transformed by Equation (6) for converting matrix components $c_{ij}''$ of i-th row and j-th column of the 2D matrix M21 such that a matrix component $C_{max}''$ corresponding to the maximum number of occurrences in data becomes 0 and the number of occurrences of 0 becomes 1 is generated.

$$c_{ij}''' = f(c_{ij}'') = (C_{max}'' - c_{ij}'')/C_{max}'' \quad \ldots \quad (6)$$

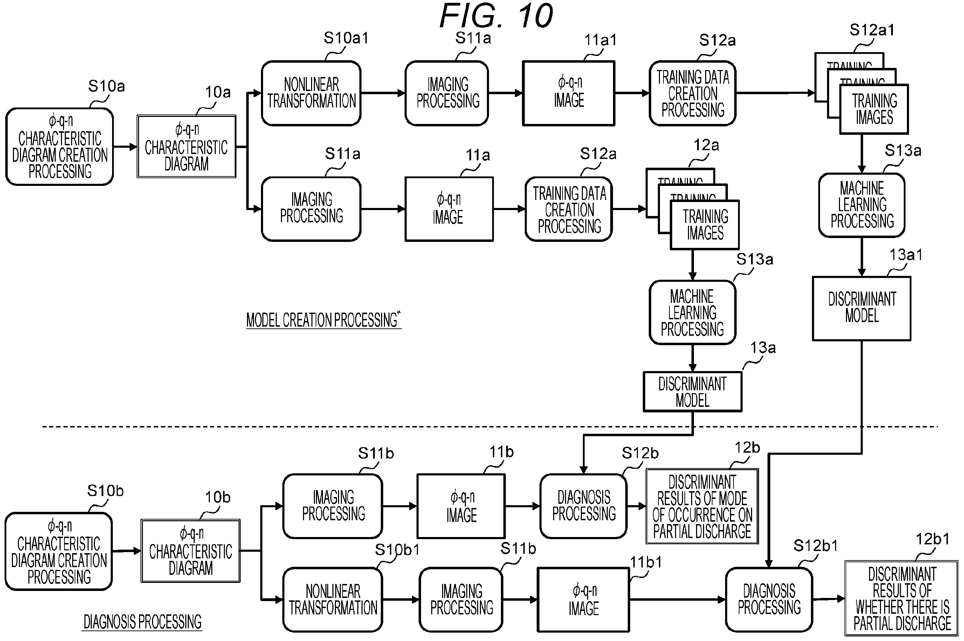

As illustrated in FIG. 8(f), a lattice image 23 is drawn as an image having a size m × n in which a lattice square of i-th row and j-th column corresponding to a matrix component $c_{ij}'''$ is colored according to a luminance, regarding $f(c_{ij}'')$ as the luminance of the light in a case where 0 is black (light intensity 0%) and 1 is white (light intensity 100%). In the lattice image 23, the larger the number of occurrences is, the closer the color is to black, and the smaller the number of occurrences is, the closer the color is to white. In the present example, the lattice images 23 are set as φ-q-n images 11a1 and 11b1 (FIG. 10).

(Model Creation Processing and Determination Processing of Partial Discharge Determination System S of Example 2)

FIG. 10 is a flowchart illustrating model creation processing and diagnosis processing of the partial discharge determination system S of Example 2.

In FIG. 10, each processing sequence of S10a, S11a, S12a and S13a of the model creation processing and SIOb, S11b, and S12b of the diagnosis processing indicate the processing of Example 1. The processing of Example 1 is effective when a sufficient time has elapsed since the insulation degradation of the insulator 1 has started, the generated charge amount of the partial discharge is sufficiently large, and the characteristic of the partial discharge is sufficiently expressed even in the φ-q-n image obtained by imaging the φ-q-n characteristic as it is.

On the other hand, during a predetermined period where insulation degradation of the insulator 1 starts, the generated charge amount of the partial discharge is very small, and the φ-q-n image obtained by imaging the φ-q-n characteristic as it is does not sufficiently express characteristics of the partial discharge. In Example 2, as illustrated in FIG. 10, the φ-q-n image creation unit 52a performs the nonlinear transformation of S10a1 with respect to the φ-q-n characteristic diagram 10a between S10a and S11a in the model creation processing. Also in the diagnosis processing, the φ-q-n image creation unit 52b performs the nonlinear transformation of S10b1 with respect to the φ-q-n characteristic diagram 10b between SIOb and S11b.

In the present example, each numerical value of the φ-q-n characteristic diagram is subject to nonlinear transformation to adjust the distribution balance between the partial discharge and the noise, thereby preventing the distribution shape in which the characteristic of the partial discharge is easily recognized, that is, a region indicating the characteristic of the partial discharge from being biased to a specific region of the histogram.

That is, by performing the nonlinear transformation on the φ-q-n characteristic diagrams 10a and 10b, the miniature partial discharge can be focused and detected, so that the sensitivity to the generated charge amount of the partial discharge can be enhanced in the model creation processing and the diagnosis processing.

Example 3

In Example 3, the processing of Example 2 in which the nonlinear transformation is performed on the φ-q-n characteristic diagrams 10a and 10b and the processing of Example 1 in which the nonlinear transformation is not performed are used in combination. The occurrence of the partial discharge may be determined by the processing of Example 2, and when it is determined that the partial discharge is present in this processing, the occurrence state of the partial discharge may be determined by the processing of Example 1. Therefore, determination with higher accuracy can be expected.

Example 4

In Examples 1 and 2, the φ-q-n characteristic diagram was imaged into a gray scale. However, the present invention is not limited to the gray scale; for example, a method of imaging into a color such as RGB expression is also conceivable. Hereinafter, color imaging will be described as Example 3.

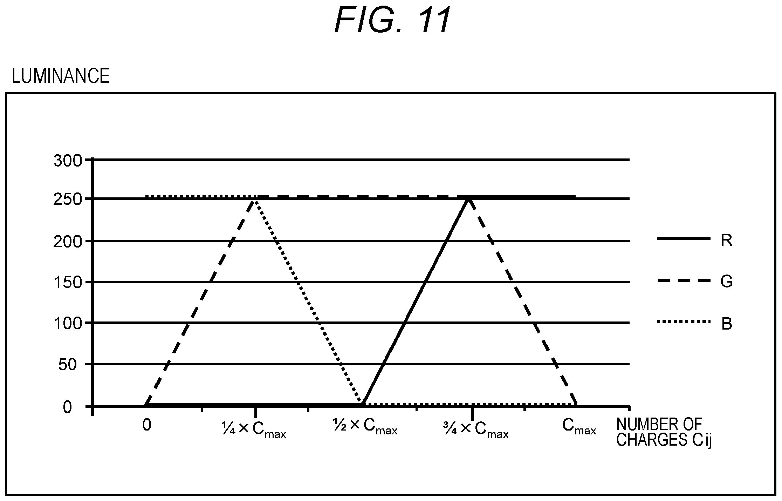

For each matrix component $c_{ij}$ of the 2D matrix M18 (FIG. 8 (a)), RGB values determined by the graph of FIG. 11 are allocated. For example, when the number of occurrences $c_{ij} = 1/4 \times C_{max}$, (R,G,B) = (0,255,255) is allocated. Similarly, (R,G,B) = (0,255,0) is allocated when the number of occurrences $c_{ij} = 1/2 \times C_{max}$, (R,G,B) = (255,255,0) is allocated when the number of occurrences $c_{ij} = 3/4 \times C_{max}$, and (R,G,B) = (255,0,0) is allocated when the number of occurrences $c_{ij} = C_{max}$. The matrix component $C_{max}$ is a matrix component corresponding to the maximum number of occurrences in the 2D matrix M18. According to the graph illustrated in FIG. 11, by allocating RGB values to the number of occurrences $c_{ij}$, a color image is obtained in which the blue color becomes stronger as the number of occurrences of partial discharge decreases, and the color image changes to green to red as the number of occurrences increases.

In a case where the 2D matrix M21 (FIG. 8(d)) is color imaged, $C_{max}$ is replaced with $C_{max}''$. $C_{max}''$ is a matrix component corresponding to the maximum number of occurrences in the 2D matrix M21.

Example 5

In Example 5, the insulation degradation diagnosis apparatus 50b creates a time series of a φ-q-n image from a time series of a φ-q-n characteristic diagram based on measurement data of the same point measured over a long period of time such as several months or years. The discriminant model is made constant, and the determination result of the presence and/or occurrence state of the partial discharge based on the time series of the φ-q-n images is compared in the time series. Accordingly, it is possible to diagnose the occurrence state of the partial discharge, that is, the specific progress of insulation degradation.

(Configurations of Computer 500 Implementing Model creation apparatus 50a and Insulation degradation diagnosis apparatus 50b)

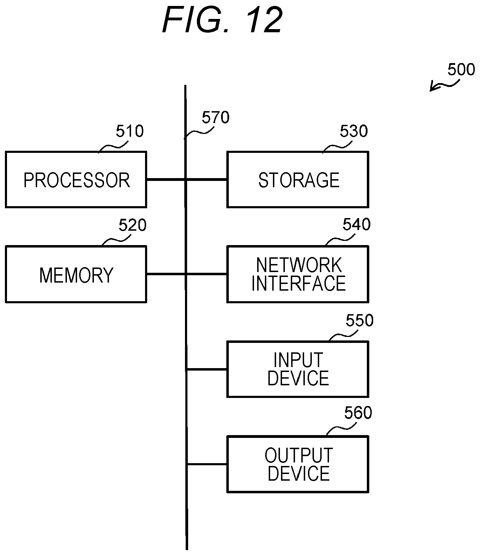

FIG. 12 is a hardware diagram of a computer that implements the model creation apparatus 50a and the insulation degradation diagnosis apparatus 50b. In the computer 500, a processor 510 (e.g. central processing unit (CPU)), a memory 520 (e.g. a random access memory (RAM)), a storage 530 (e.g. hard disk drive (HDD), solid state drive (SSD) and medium reading device), a network interface 540, an input device 550 (e.g. keyboard, mouse and touchscreen), and an output device 560 (e.g. display and printer) are connected to each other via a bus 570.

In the computer 500, each program for implementing the model creation apparatus 50a and the insulation degradation diagnosis apparatus 50b is read from the storage 530 and executed by cooperation of the processor 510 and the memory 520, so that the model creation apparatus 50a and the insulation degradation diagnosis apparatus 50b are implemented. Alternatively, each program for implementing the model creation apparatus 50a and the insulation degradation diagnosis apparatus 50b may be acquired from an external computer by communication via the network interface 540. Alternatively, each program for implementing the model creation apparatus 50a and the insulation degradation diagnosis apparatus 50b may be recorded in a portable nontransitory recording medium (e.g. optical disk and semiconductor storage medium), read by a medium reading device, and executed by cooperation of the processor 510 and the memory 520.

The examples above have been described in detail in order to describe the present invention for better understanding, and are not necessarily limited to those having all the described configurations. Each device in the plurality of examples and modifications described above may appropriately be integrated and distributed in terms of mounting or processing efficiency, and is not limited to a single device, and may be a system consisting of a plurality of devices. Furthermore, in the plurality of examples and modifications described above, a change in a device or system configuration, omission, replacement or combination of a part of a configuration or processing procedure, combination within a range not departing from the gist of the present invention. Moreover, only control lines and information lines considered to be necessary for description are illustrated in the functional block diagram and the hardware diagram, and not all the lines are necessarily illustrated. Reference Signs List

S        partial discharge determination system
13a      discriminant model
50a      model creation apparatus
51a      φ-q-n characteristic diagram creation unit
52a      φ-q-n image creation unit
53a      training data creation unit
54a      model creation processing unit
50b      insulation degradation diagnosis apparatus
51b      φ-q-n characteristic diagram creation unit
52b      φ-q-n image creation unit
53b      diagnosis unit
54b      output processing unit
500      computer
510      processor
520      memory

**Claims**

1. An insulation degradation diagnosis model creation apparatus that creates an insulation degradation diagnosis model based on a partial discharge signal of an insulator, the device comprising:

   a characteristic diagram creation unit configured to create a φ-q-n characteristic diagram of a partial discharge signal of an insulator for learning;
   an image creation unit configured to create a φ-q-n image having each pixel value based on each numerical value of the φ-q-n characteristic diagram; and
   a model creation unit configured to create the insulation degradation diagnosis model by learning the φ-q-n image as training data associated with a presence or occurrence state of partial discharge.

2. The insulation degradation diagnosis model creation apparatus according to claim 1, further comprising:

   a training data creation unit configured to perform data augmentation on the training data by superimposing random noise or shifting a charge generation phase on the φ-q-n image,
   wherein the model creation unit is configured to create the insulation degradation diagnosis model by learning the training data subject to the data augmentation by the learning data creation unit.

3. The insulation degradation diagnosis model creation apparatus according to claim 1,

   wherein the image creation unit is configured to perform nonlinear transformation on each numerical value in the φ-q-n characteristic diagram to create a φ-q-n image having each pixel value based on each numerical value subject to the nonlinear transformation, and
   the model creation unit is configured to create the insulation degradation diagnosis model by learning the φ-q-n image created by the image creation unit as the training data.

4. The insulation degradation diagnosis model creation apparatus according to claim 1, wherein the φ-q-n image is a grayscale image.

5. The insulation degradation diagnosis model creation apparatus according to claim 1, wherein the φ-q-n image is a color image.

6. An insulation degradation diagnosis apparatus that performs insulation degradation diagnosis based on a partial discharge signal of an insulator, the device comprising:

   a characteristic diagram creation unit configured to create a φ-q-n characteristic diagram of a partial discharge signal of an insulator to be determined;
   an image creation unit configured to create a φ-q-n image having each pixel value based on each numerical value of the φ-q-n characteristic diagram; and
   a diagnosis unit configured to make a diagnosis on a presence or occurrence state of partial discharge in the insulator to be determined from the φ-q-n image using an insulation degradation diagnosis model created by the insulation degradation diagnosis model creation apparatus as set forth in claim 1 or 2.

7. An insulation degradation diagnosis apparatus that performs insulation degradation diagnosis based on a partial discharge signal of an insulator, the device comprising:

   a characteristic diagram creation unit configured to create a φ-q-n characteristic diagram of a partial discharge signal of an insulator to be determined;
   an image creation unit configured to perform nonlinear transformation on each numerical value of the φ-q-n characteristic diagram and to create a φ-q-n image having each value based on each numerical value subject to the nonlinear transformation; and
   a diagnosis unit configured to make a diagnosis on a presence or occurrence state of partial discharge in the insulator to be determined from the φ-q-n image using an insulation degradation diagnosis model created by the insulation degradation diagnosis model creation apparatus as set forth in claim 3.

8. An insulation degradation diagnosis apparatus that performs insulation degradation diagnosis based on a partial discharge signal of an insulator, the device comprising:

a characteristic diagram creation unit configured to create a φ-q-n characteristic diagram of a partial discharge signal of an insulator to be determined;

an image creation unit configured to create a first φ-q-n image having each pixel value based on each numerical value of the φ-q-n characteristic diagram, and to perform nonlinear transformation on each numerical value of the φ-q-n characteristic diagram to create a second φ-q-n image having each value based on each numerical value subject to the nonlinear transformation; and

a diagnosis unit configured to make a diagnosis on a presence of partial discharge in the insulator to be determined from the second φ-q-n image using an insulation degradation diagnosis model created by the insulation degradation diagnosis model creation apparatus as set forth in claim 3, and, in a case where it is diagnosed that the partial discharge exists, to make a diagnosis on an occurrence state of the partial discharge in the insulator to be determined from the first φ-q-n image using an insulation degradation diagnosis model created by the insulation degradation diagnosis model creation apparatus as set forth in claim 1 or 2.

9. An insulation degradation diagnosis apparatus that performs insulation degradation diagnosis based on a partial discharge signal of an insulator, the device comprising:

a characteristic diagram creation unit configured to create a φ-q-n characteristic diagram of a partial discharge signal of an insulator to be determined during a predetermined period;

an image creation unit configured to create a φ-q-n image having each pixel value based on each numerical value of the φ-q-n characteristic diagram of the predetermined period; and

a diagnosis unit configured to make a diagnosis, depending on the determination results on a presence or occurrence state of partial discharge in the insulator to be determined, on a degradation state of the partial discharge, from the φ-q-n image of the predetermined period using an insulation degradation diagnosis model created by the insulation degradation diagnosis model creation apparatus as set forth in claim 1 or 2.

10. The insulation degradation diagnosis apparatus according to any one of claims 6 to 9, wherein the φ-q-n image is a grayscale image.

11. The insulation degradation diagnosis apparatus according to any one of claims 6 to 9, wherein the φ-q-n image is a color image.

12. An insulation degradation diagnosis method based on a partial discharge signal of an insulator, which is executed by an insulation degradation diagnosis apparatus, the method comprising:

creating a φ-q-n characteristic diagram of a partial discharge signal of an insulator to be determined;

creating a φ-q-n image having each pixel value based on each numerical value of a φ-q-n characteristic diagram; and

making a diagnosis on a presence or occurrence state of partial discharge in the insulator to be determined, using an insulation degradation diagnosis model which is created by learning a φ-q-n image having each pixel value based on each numerical value of a φ-q-n characteristic diagram of a partial discharge signal of an insulator for learning as training data associated with a presence or occurrence state of partial discharge.

# FIG. 1

# FIG. 2

# FIG. 3

# FIG. 4

(a)

CHARGE AMOUNT

TIME

PHASE

CUMULATIVE

(b)

NUMBER OF OCCURRENCES

CHARGE AMOUNT

A  B  C ...

D  E  F

...

PHASE

# FIG. 5

EP 4 321 881 A1

## FIG. 6

**INSTRUMENT** — 17

- GROUND LINE CURRENT ACQUISITION UNIT — 171
- APPLIED VOLTAGE ACQUISITION UNIT — 172
- A/D CONVERSION UNIT — 173
- GENERATED CHARGE AMOUNT CALCULATION UNIT — 174
- VOLTAGE PHASE ANGLE CALCULATION UNIT — 175
- $\phi$-q CHARACTERISTIC DIAGRAM CREATION UNIT — 176

**MODEL CREATION APPARATUS** — 50a

- $\phi$-q-n CHARACTERISTIC DIAGRAM CREATION UNIT — 51a
- $\phi$-q-n IMAGE CREATION UNIT — 52a
- TRAINING DATA CREATION UNIT — 53a
- MODEL CREATION PROCESSING UNIT — 54a

**INSULATION DEGRADATION DIAGNOSIS APPARATUS** — 50b

- $\phi$-q-n CHARACTERISTIC DIAGRAM CREATION UNIT — 51b
- $\phi$-q-n IMAGE CREATION UNIT — 52b
- DIAGNOSIS UNIT — 53b
- OUTPUT PROCESSING UNIT — 54b

DISCRIMINANT MODEL — 13a

S

*FIG. 7*

# FIG. 8

(a)

(b)

(c)

n-TH COLUMN

CHARGE

M18

A  B  C ...

D  E  F

... NUMBER OF OCCURRENCES

m-TH ROW

PHASE

NORMALIZATION →

M19

0.2  0.0  0.3 ...

0.0  0.1  0.2

...

PHASE

MONOCHROMIC IMAGING →

20

↓ NONLINEAR TRANSFORMATION

(d)

(e)

(f)

CONVERTED VALUE OF NUMBER OF OCCURRENCES

CHARGE

A'  B'  C' ...

D'  E'  F'

...

PHASE

M21

NORMALIZATION →

0.3  0.1  0.8 ...

0.0  0.0  0.1

...

PHASE

M22

MONOCHROMIC IMAGING →

23

EP 4 321 881 A1

# FIG. 9

**MODEL CREATION PROCESSING**

S10a — φ-q-n CHARACTERISTIC DIAGRAM CREATION PROCESSING → 10a — φ-q-n CHARACTERISTIC DIAGRAM → S11a — IMAGING PROCESSING → 11a — φ-q-n IMAGE → S12a — TRAINING DATA CREATION PROCESSING → 12a — TRAINING IMAGES → S13a — MACHINE LEARNING PROCESSING → 13a — DISCRIMINANT MODEL

**DIAGNOSIS PROCESSING**

S10b — φ-q-n CHARACTERISTIC DIAGRAM CREATION PROCESSING → 10b — φ-q-n CHARACTERISTIC DIAGRAM → S11b — IMAGING PROCESSING → 11b — φ-q-n IMAGE → S12b — DIAGNOSIS PROCESSING → 12b — DISCRIMINANT RESULTS OF WHETHER THERE IS PARTIAL DISCHARGE AND ON MODE OF OCCURRENCE

FIG. 10

# FIG. 11

LUMINANCE

EP 4 321 881 A1

## FIG. 12

```
                          570
            510                         530
   ┌─────────────┐  │   ┌─────────────┐
   │  PROCESSOR  │──┼───│   STORAGE   │
   └─────────────┘  │   └─────────────┘
            520     │            540
   ┌─────────────┐  │   ┌─────────────┐
   │   MEMORY    │──┼───│   NETWORK   │
   └─────────────┘  │   │  INTERFACE  │
                    │   └─────────────┘
                    │            550
                    │   ┌─────────────┐
                    ├───│    INPUT    │
                    │   │   DEVICE    │
                    │   └─────────────┘
                    │            560
                    │   ┌─────────────┐
                    ├───│   OUTPUT    │
                    │   │   DEVICE    │
                    │   └─────────────┘
```

500

**INTERNATIONAL SEARCH REPORT**

| International application No. |
|---|
| **PCT/JP2022/013505** |

### A. CLASSIFICATION OF SUBJECT MATTER

*G01R 31/12*(2020.01)i; *G01R 31/14*(2006.01)i
FI:   G01R31/12 A; G01R31/14

According to International Patent Classification (IPC) or to both national classification and IPC

### B. FIELDS SEARCHED

Minimum documentation searched (classification system followed by classification symbols)

G01R31/12; G01R31/14

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | 伴野 幸造 BANNO, Kozo et al. 機械学習を用いたスイッチギヤの絶縁劣化診断技術, 東芝レビュー TOSHIBA REVIEW. 24 September 2019 (accession date), vol. 74, no. 5 [online], pp. 17-21<br>    1. Introduction, 2. Insulation deterioration diagnosis process for Switchgears, 3. Identification of defect species, 4. Degradation state estimation, fig. 3-9, (Insulation Deterioration Diagnosis Technique for Switchgears Using Machine Learning) | 1, 4-6, 9-12 |
| Y | | 3, 7-8 |
| A | | 2 |
| Y | JP 2005-331415 A (TOENEC CORP) 02 December 2005 (2005-12-02)<br>    paragraph [0003] | 3, 7-8 |
| A | JP 2011-232288 A (MITSUBISHI ELECTRIC CORP) 17 November 2011 (2011-11-17)<br>    entire text, all drawings | 1-12 |
| A | JP 11-258296 A (FUJIKURA LTD) 24 September 1999 (1999-09-24)<br>    entire text, all drawings | 1-12 |

☑ Further documents are listed in the continuation of Box C.      ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 May 2022** | **07 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2022/013505**

| C. | DOCUMENTS CONSIDERED TO BE RELEVANT | | |
|---|---|---|
| Category* | Citation of document, with indication, where appropriate, of the relevant passages | Relevant to claim No. |
| A | WO 2016/088179 A1 (SUMITOMO ELECTRIC INDUSTRIES) 09 June 2016 (2016-06-09) entire text, all drawings | 1-12 |
| A | JP 2001-133506 A (HITACHI LTD) 18 May 2001 (2001-05-18) entire text, all drawings | 1-12 |

Form PCT/ISA/210 (second sheet) (January 2015)

**INTERNATIONAL SEARCH REPORT**
Information on patent family members

International application No.

**PCT/JP2022/013505**

| Patent document cited in search report | | | Publication date (day/month/year) | Patent family member(s) | Publication date (day/month/year) |
|---|---|---|---|---|---|
| JP | 2005-331415 | A | 02 December 2005 | (Family: none) | |
| JP | 2011-232288 | A | 17 November 2011 | (Family: none) | |
| JP | 11-258296 | A | 24 September 1999 | (Family: none) | |
| WO | 2016/088179 | A1 | 09 June 2016 | CN 107110909 A<br>entire text, all drawings | |
| JP | 2001-133506 | A | 18 May 2001 | (Family: none) | |

Form PCT/ISA/210 (patent family annex) (January 2015)

**EP 4 321 881 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0580112 A
- JP 2020030125 A
- JP 2020046202 A
- JP 2019200068 A